# EUROPEAN PATENT APPLICATION

(11) **EP 0 840 364 A1**
(43) Date of publication of application: **06.05.1998**
(21) Application number: 97117871.0
(22) Date of filing: 15.10.1997
(51) Int. Cl.: H01L 21/304, G03F 7/12, B24C 1/04

(54) **Method of forming a semiconductor device**

(30) Priority: 30.10.1996 US 740526
(71) Applicant: MOTOROLA, INC., Schaumburg, IL 60196 (US)
(72) Inventor: Snider, Todd D., Gilbert, AZ 85234 (US)
(74) Representative: Gibson, Sarah Jane

(57) **Abstract**

A surface (13) of a semiconductor wafer (11) is sandblasted in order to remove material and form trenches (19) in the surface (13). A sandblasting resistant mask (14) is used to mask the surface (13) during the sandblasting operation.

## Description

### Background of the Invention

The present invention relates, in general, to semiconductor devices, and more particularly, to semiconductor formation techniques.

A variety of techniques have been utilized by the semiconductor industry in order to pattern or form structures on semiconductor wafers. Such techniques generally involve etching the wafers utilizing chemical or reactive ion etching techniques. Reactive ion etching (RIE) is rather slow when forming large numbers of deep trenches in a semiconductor wafer. One particular type of chemical etching known as "spin etching" is faster than RIE techniques but often results in non-uniform dimensions across a semiconductor wafer. Often, spin etching over-etches thereby rounding the sides of square shaped features and producing features that appear more as triangles. Additionally, spin etching requires hard masks, such as masks made from metals, which are very expensive.

Accordingly, it is desirable to have a semiconductor formation method that has low costs, that has a high throughput, that results in uniform dimensions across a semiconductor wafer, and that utilizes inexpensive mask techniques.

### Brief Description of the Drawings

FIG. 1 illustrates an enlarged cross-sectional portion of a semiconductor device at a stage of manufacturing in accordance with the present invention; and
FIG. 2 illustrates the semiconductor device of FIG. 1 at a subsequent manufacturing stage in accordance with the present invention.

### Detailed Description of the Drawings

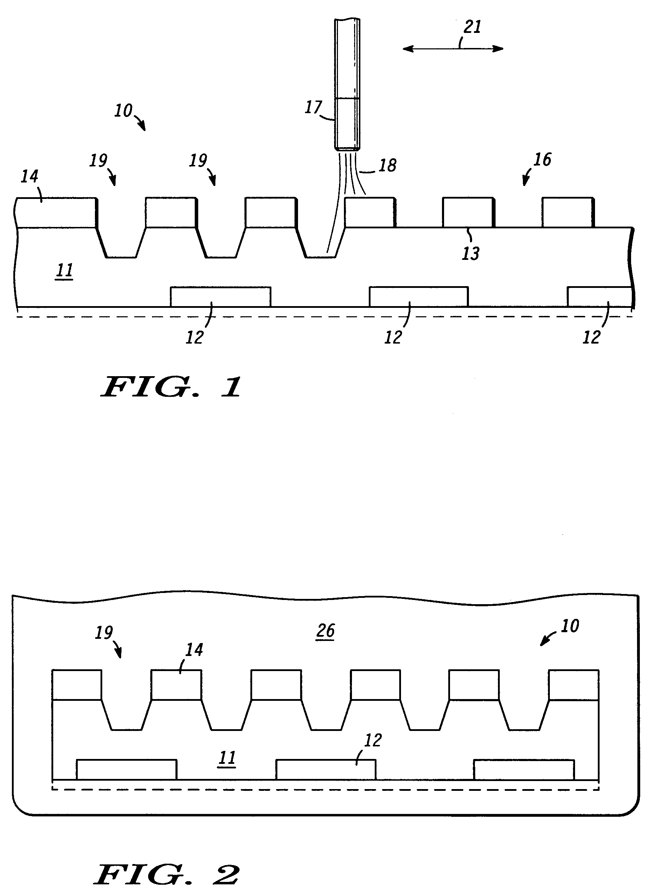

FIG. 1 illustrates an enlarged cross-sectional portion of a semiconductor device 10 at the stage of manufacturing. Device 10 includes a semiconductor wafer or substrate 11 that has active areas 12 on a surface of substrate 11 in order to form an active semiconductor device. Typically, active areas 12 are covered with a polymer material or other encapsulant (shown in phantom) that is used to protect areas 12. As will be seen hereinafter, patterns or features are to be formed in a surface 13 that is opposite the surface wherein areas 12 are formed. In order to pattern surface 13, an optically activated or photosensitive or photomask material is applied to surface 13 and then patterned using standard photo-masking or photosensitive mask making techniques that are well known to those skilled in the art. Patterning the photo-mask material results in a mask 14 on surface 13. Consequently, mask 14 is patterned while on surface 13 to expose a portion or portions 16 of underlying surface 13. As will be seen hereinafter, the material used for mask 14 must not only be photosensitive but also must be able to withstand sandblasting operations that will be performed on exposed portions 16 of surface 13. One particular material that is suitable for forming mask 14 is known as SBX Liquid Emulsion(TM) and is manufactured by PhotoBrasive Systems of Duluth, Minnesota. Often, it is necessary to align mask 14 to features on the opposite surface of wafer 11. one method of performing such operations utilizes a front-to-back contact aligner as is well known in the art.

After patterning mask 14, exposed portions 16 of surface 13 are sandblasted in order to form grooves or trenches 19 in surface 13. Forming trenches 19 results in creating features on surface 13. Sandblasting of portions 16 can also be utilized to form other structures or features as will be noted by one skilled in the art. The sandblasting operation is performed by directing a stream of particles 18 toward surface 13, thus, impinging particles 18 onto surface 13 and exposed portions 16. The sandblasting removes material from substrate 11 resulting in trenches 19. It is preferable if particles 18 impinge substantially perpendicular to surface 13, although other angles may be used. Typically, high pressure air is utilized to project particles 18 through an orifice or nozzle 17 toward surface 13. Particles 18 can be a variety of material typically used for sandblasting, including small aluminum oxide spheres.

In order to cover the entire surface of substrate 11, nozzle 17 is reciprocated transversely across substrate 11, as shown by an arrow 21, thereby reciprocating stream of particles 18 therewith. Meanwhile, substrate 11 is moved in a plane parallel to surface 13 and in a direction that is perpendicular to arrow 21. For example, nozzle 17 is reciprocated across substrate 11 along the direction of arrow 21 while substrate 11 is moved in a direction that is perpendicular to the page. This movement ensures the entire surface of substrate 11 is covered by particles 18. In one embodiment, substrate 11 is placed on a conveyer belt that carries substrate 11 under nozzle 17 while nozzle 17 reciprocates across the surface of substrate 11 in a direction that is perpendicular to the movement of the conveyer belt. One example of equipment suitable for such a sandblasting operation is a Swam C-129(TM) sandblasting machine manufactured by Crystal Mark, Inc. of Glendale, Ca.

The orifice used for expelling particles 18 and the size of particles 18 must be sufficient to provide the resolution needed to form trenches 19 in surface 13. In one example, trenches 19 are formed to a depth and a width of one to seven hundred microns with a spacing between closest trenches of one to seven hundred microns. To form such features, particles 18 are aluminum oxide ceramic particles having a diameter of one to twenty-five microns, and orifice 17 has a size of seventy five to eight hundred ninety microns in order to expel the particles toward surface 13. For smaller trench widths, the particles can have a size less than one micron. In this example, an air pressure of approximately three to ten Kgf/cm sq is utilized to ensure the particles remove material from substrate 11. To control the feature size, the orifice is reciprocated at thirty to seventy-five strokes per minute while the wafer moves at a speed of ten to fifteen cm/min.

FIG. 2 illustrates a chemical etch operation that typically is utilized after performing the sandblasting operation in order to remove subsurface damage caused by the sandblasting operation. Generally, a bulk chemical etch utilizing NH_{3,} HF, H₂SO_{4,} and HP is utilized to chemically etch exposed portions of surface 13 for approximately 30 seconds. Thereafter, mask 14 is removed using conventional photoresist stripping techniques that are well know to those skilled in the art.

By now, it should be appreciated that there has been provided a novel method of forming structures or features on a semiconductor device. Utilizing sandblasting techniques results in higher throughput and lower cost than using reactive ion etching. Sandblasting techniques also result in features having well defined and well formed dimensions and edges. Utilizing conventional photo exposure and mask making equipment results in lower cost than using expensive hard mask thereby resulting in low manufacturing cost.

## Claims

1. A method of forming a semiconductor device comprising:
patterning a mask on a first surface of the semiconductor device to expose a portion of the first surface; and
sandblasting the portion of the first surface.

2. The method of claim 1 wherein providing paterming the mask on the first surface of the semiconductor device includes using a semiconductor device having active areas formed on a second surface that is opposite to the first surface.

3. The method of claim 1 or 2 further including performing a chemical etch of the first surface after performing the sandblasting step, and removing the mask after performing the chemical etch.

4. The method of claim 1 or 2 or 3 wherein sandblasting the portion of the first surface includes forming trenches having a width and a depth of one to seven hundred microns.

5. The method of claim 1 or 2 or 3 or 4 wherein sandblasting the portion of the first surface includes directing a stream of ceramic particles onto the first surface wherein the ceramic particles have a diameter less than 1 micron.

6. The method of claim 1 or 2 or 3 or 4 or 5 wherein sandblasting the portion of the first surface includes impinging particles perpendicularly to the first surface and moving the semiconductor device in a direction parallel to the first surface.

7. The method of claim 6 wherein impinging particles includes moving an emitter of the particles transversely to the direction parallel to the first surface.

8. The method of claim 1 or 2 or 3 or 4 or 5 or 6 or 7 wherein patterning the mask includes forming a mask that is optically activated and is resistant to sandblasting.
